# EUROPEAN PATENT APPLICATION

(11) **EP 3 725 911 A1**
(43) Date of publication of application: **21.10.2020**
(21) Application number: 19169438.9
(22) Date of filing: 16.04.2019
(51) Int. Cl.: C23C 14/28, C23C 14/54

(54) **SOURCE ARRANGEMENT, DEPOSITION APPARATUS AND METHOD FOR DEPOSITING SOURCE MATERIAL**

(71) Applicant: Max-Planck-Gesellschaft zur Förderung der Wissenschaften e.V., 80539 München (DE)
(72) Inventor: Braun, Wolfgang, 74321 Bietigheim-Bissingen (DE)
(74) Representative: Manitz Finsterwald Patent- und Rechtsanwaltspartnerschaft mbB

(57) **Abstract**

The invention relates to a source arrangement for a deposition apparatus with a direct surface heater comprising a holding structure with a support and at least one source element comprising, in particular consisting of, a source material and arranged at the support, the source element comprising a source surface and a second surface opposite to the source surface, wherein the source material can be vaporized and/or sublimated from a source area on the source surface when heated by the surface heater of the deposition apparatus. Further, the invention is related to a deposition apparatus comprising such a source arrangement and to a method for depositing source material on a target material in the deposition apparatus, whereby the deposition apparatus comprises a surface heater and such a source arrangement.

## Description

The present invention relates to a source arrangement for a deposition apparatus with a direct surface heater, comprising a holding structure with a support and at least one source element comprising, in particular consisting of, a source material and arranged at the support, the source element comprising a source surface and a second surface opposite of the source surface, wherein source material can be vaporized and/or sublimated from a source area on the source surface when heated by the surface heater of the deposition apparatus. Further, the present invention relates to a deposition apparatus comprising a source arrangement with a source element, a target arrangement with a target element, a reaction chamber comprising a wall and containing a reaction atmosphere, an atmosphere controller configured to control the reaction atmosphere and a surface heater configured to heat a source area on the source surface of the source element, whereby the source arrangement and the target arrangement are positioned within the reaction atmosphere in the reaction chamber such that the source material can be deposited on the target element in a controlled way by heating the source area by usage of the surface heater by applying a heating power onto a heating spot on the source surface. Additionally, the present invention relates to a method for depositing source material on a target material in a deposition apparatus, the deposition apparatus comprising a surface heater and a source arrangement.

Deposition of a source material to a target material is a technique widely used in modern technology, for instance in the production of specialized semiconductors for electronic elements. A highly controlled environment, in particular with respect to a pressure and/or a composition of a reaction atmosphere, is essential to provide a deposition of the source material onto the taught material in high and/or highest quality. Even a deposition of a single atomic layer of the source material can be achieved.

In the deposition apparatus, the source material can be vaporized and/or sublimated from a source area using a direct surface heater. To achieve a deposition of the source material with high quality, it is necessary to control not only the reaction atmosphere but also the rate with which the source material is deposited onto the target material.

To control the aforementioned deposition rate, it is known in the state of the art to measure an energy consumption of the direct surface heater, for instance an electron beam source, and to calculate based on this measurement the amount of energy deposited onto the surface area of the source material. By that a deposition rate of the source material can be calculated at least in an indirect way and by adjusting the energy consumed by the direct surface heater an at least indirect control of the deposition rate can be achieved.

Unfortunately, this method according to the state of the art comprises several sources for inaccuracy and errors. For instance, a dissipation of the energy provided by the direct surface heater into the reaction atmosphere can lead to a reduction in the deposition rate. Also, misalignments of the direct surface heater lead to a decrease in energy deposited onto the surface material and therefore also in a reduction of the deposition rate. In summary, the high-quality standards necessary to achieve excellent deposition results can frequently not be provided.

In view of the above, it is an object of the present invention to provide an improved source arrangement for a deposition apparatus, a deposition apparatus and a method for depositing source material on a target material in a deposition apparatus which do not have the aforementioned drawbacks of the state of the art. In particular it is an object of the present invention to provide a source arrangement, a deposition apparatus and a method which allow a control of a deposition rate with high accuracy in an especially easy and cost-efficient way.

This object is satisfied by the patent claims. In particular, this object is satisfied by a source arrangement for a deposition apparatus according to claim 1, by a deposition apparatus according to claim 11 and by a method for depositing source material on a target material in a deposition apparatus according to claim 13. The dependent claims describe preferred embodiments of the invention. Details and advantages described with respect to a source arrangement according to the first aspect of the invention also refers to a deposition apparatus according to the second aspect of the invention and to a method for depositing source material on a target material according to the third aspect of the invention and vice versa, if of technical sense.

According to a first aspect of the invention, the object is satisfied by a source arrangement for a deposition apparatus with a direct surface heater, comprising a holding structure with a support and at least one source element comprising, in particular consisting of, a source material and arranged at the support, the source element comprising, in particular comprising a source surface and a second surface opposite of the source surface, wherein source material can be vaporized and/or sublimated by a source area on the source surface when heated by the surface heater of the deposition apparatus, wherein the source arrangement comprises a temperature sensor for a temperature measurement at the source element.

A source arrangement according to the first aspect of the invention is intended for a usage in a deposition apparatus with a direct surface heater. In other words, the source arrangement can be positioned within a reaction chamber of the deposition apparatus and a source material provided by the source arrangement according to the first aspect of the invention can be vaporized and/or sublimated with the direct surface heater of the deposition apparatus. For this purpose, the source arrangement comprises a holding structure with a support and at least one source element comprising, particularly, consisting of, a source material. The source element is arranged at the support, preferably directly arranged at the support. In other words, except of the support of the holding structure preferably no further support elements are needed to fix the source element in the source arrangement according to the invention. Especially crucibles containing the source material can be avoided if the at least one source element consists only of the source material. This allows a simple and pure evaporation and/or sublimation, as the source material is not contaminated by the crucible, nor can the source material react with such a crucible. In addition, the surfaces of the source element not used for evaporation and/or sublimation are preferably not covered by additional elements and can therefore be used for radiation cooling. This is especially advantageous for source materials with low vapor pressures as for instance molybdenum, tantalum or tungsten.

In particular, a source arrangement according to the invention comprises a temperature sensor for a temperature measurement at the source element. In other words, the temperature sensor of the source arrangement can provide a direct temperature measurement of the source material of the source element. This allows to base an adjustment of the heating power of the direct surface heater on the temperature of the source element, and actively to establish a feedback mechanism, whereby the temperature of the source element can be used as input variable and the heating power of the direct surface heater can accordingly be adjusted. Especially, a closed loop control for the heating power of the direct surface heater can be established based on the measured temperatures of the source element. In summary, as the rate with which source material is vaporized and/or sublimated from a source area on the source surface of the source element is directly dependent on a temperature of the source element, a deposition rate of the vaporized and/or sublimated source material onto a target material in the deposition apparatus can be provided with high accuracy and constancy.

Further, a source arrangement according to the invention can be characterized in that the temperature sensor is arranged at the second surface of the source element, in particular wherein the temperature sensor is arranged at and/or near a symmetric center of the second surface and/or the first element. Such an arrangement of the temperature sensor at the second surface of the source element, with the second surface being located opposite to the source surface, can be easily provided as the source element preferably is directly supported by the support of the holding structure without any further support elements as for instance crucibles. In other words, additionally to the source surface also the second surface of the source element is at least partly directly accessible. Further, the second surface is not heated by the direct surface heater and therefore a contamination of the temperature sensor by vaporized and/or sublimated source material can be avoided. Then again, as the source element might comprise a small thickness between the source surface and the second surface, a temperature measurement of the source element, with which a sufficiently exact temperature distribution the whole source element can be achieved, can be provided by arranging the temperature sensor at the second surface of the source element.

An arrangement of the temperature sensor at and/or near to a symmetric center of the second surface and/or the source element as a whole is of an advantage as in most of the cases also the source area, where the vaporization and/or sublimation of the source material takes place, is also arranged at and/or near a symmetric center of the source and/or the source element, but on the source surface. A distance of the position of the temperature sensor to the source area, the hottest part of the source element, can thereby be minimized and an accuracy of the temperature measurement can be enhanced.

In this connection it should be noted that the symmetric center is the geometric center, i.e. the point at the center of a circle, the center of a line between the two foci of an ellipse.

Further, a source arrangement according to the invention can be improved by that the second surface comprises an inlet guide section for guiding the temperature center into its position, in particular an at least partially conical and/or cylindrical inlet guide section, arranged at the source element at a symmetric center of the second surface and/or the source element, preferably extending inward into the source element. Such an inlet guide section can be used to mechanically guide the temperature sensor at its designated position. In particular, even after removing the temperature sensor, at the next positioning the inlet guide section ensures an identical placement of the temperature sensor. An at least partially conical and/or cylindrical inlet guide section is preferred as these are rotationally symmetric and therefore no radial direction is preferred and/or deprived. An arrangement of the inlet guide section at the source element at the symmetric center of the second surface and/or the source element as a whole allows an especially easy way for positioning the temperature sensor at this symmetric center.

Additionally, the inlet guide section can extend inwardly into the source element and therefore reducing the distance between the temperature sensor and the surface area on the source surface, whereby at this source area the vaporization and/or sublimation of the first material takes place. As mentioned above, a temperature measurement at such a position within the source element which is located at an especially small distance to the source area helps to improve the accuracy of the temperature measurement and the corresponding control of the heating power of the direct surface heater.

In addition, a source arrangement according to the invention can be characterized in that the temperature sensor is arranged in direct contact with the second surface, wherein in particular the temperature sensor comprises a thermocouple element, and/or the temperature sensor is arranged spaced to the second surface, wherein in particular the temperature sensor comprises a pyrometer element. A temperature sensor arranged in direct contact with the second surface is a preferred embodiment in all situations, in which the expected temperature of the source element is lower than a temperature bearable by the temperature sensor. This includes limits set by possible reactions such as, e.g. the formation of a eutectic between the source element and the temperature sensor. Thermocouple elements are preferred temperature sensors for these cases. In other cases, where the expected maximum temperature of the source material is higher than a temperature bearable by the temperature sensor, for instance if a source material with an extremely high melting point such as tungsten is used, a direct contact between the temperature sensor and the source element has to be avoided. Otherwise, the temperature sensor might be damaged and/or destroyed. For these cases, an arrangement of the temperature sensor spaced to the second surface of the source element is of an advantage. Pyrometers are preferred embodiments of temperature sensors for these cases.

It is a further embodiment of the source arrangement according to the invention, wherein the at least one source element is supported by the support at three or more, preferably at three, support positions, wherein the contact areas between the support and the source element at the support positions are point-like or at least essentially point-like contact areas. In other words, the source element is in this preferred embodiment a self-supporting structure with an integral body element made out of source material.

In this connection point or point like may mean that the support has a needle-like portion, i.e. a portion that tapers to a tip, and the source element is positioned at these tips of the support.

As contact areas between the source element and the support of the holding structure are always source for contamination, these contact areas preferably are minimized. This can be achieved in this preferred embodiment by providing point-like or at least essentially point-like contact areas. Three of these contact areas is the minimum number to provide a secure and stable positioning and support for the source element. Therefore, by providing three support positions with point-like contact areas, a risk of contamination of the source material by the material of the holding structure is minimized without sacrificing a stable and secure support of the source element within the holding structure.

Apart from avoiding contamination of the source material, a reduced contact area and especially a reduced temperature at these contact areas also help avoiding possible chemical reactions between a source material and a support material. In particular, an alloying, e.g. by forming a eutectic mixture that has a lower melting point than both the support material and the source material, can be avoided. Especially with metallic materials used both for the support and the source element, such a forming of a eutectic mixture may lead to melting and failure of the support at temperatures below the individual melting points of the source material or the support material.

In addition, by locating the temperature sensor and the contact areas between the support and the source element in essentially orthogonal directions from the source area heated by the surface heater, the temperature offset and heat flow from the source area to the temperature sensor and to the support can be independently optimized. For example, in an essentially disc shaped source element with the source area located at the center of the source surface, the temperature sensor located at the center of the second surface and the contact areas between the support and the source element located at the radial rim of the disc, essentially the thickness of the disc in the axial direction determines the temperature offset between the source surface, in particular the source area, and temperature sensor, while the diameter of the disc determines the temperature offset between the source surface, in particular the source area, and the support. As particular dimensions of the thickness and of the diameter are orthogonal to each other, they can be independently chosen. Hence, the temperature drop both from the source area to the temperature sensor and the support, respectively, can independently be optimized.

The goal to be achieved by this optimization is to keep the overall surface of the body of the source element as small as possible to be able to achieve the highest possible temperature at the source area with minimum heating power, and to keep the volume of the source element large to be able to evaporate large amounts of material, while at the same time avoiding chemical reactions or alloy/eutectic formation at the contact areas to the temperature sensor and the support, both of which temperatures are, at least for pure elements, usually well-known from established phase diagrams.

As typically the source material is a homogeneous, ultrapure single chemical element, the geometry of the body of the source element is well determined, e.g. preferably rotationally symmetric, the emitting surfaces are clean, at least at low pressures, and heat dissipation is strongly dominated by radiation at high temperatures, this optimization can be done reliably through numerical computations, in particular finite element numerical simulations, for each source material. This saves time and effort, as each source material has different bulk thermal conductivity and surface emissivity values and therefore needs to be shaped differently and optimized separately to reach the optimization goal. Doing this entirely through test experiments would require a significant effort.

Preferably, a source arrangement according to the invention is improved by that the at least one source element and/or the support comprise conical protrusions for providing the point-like or at least essentially point-like contact areas between the support and the at least one source element. Cones provide a basis and a point-like tip. By the usage of conical protrusions these features of cones can be used to provide point-like or at least essentially point-like contact areas. As the conical protrusions are provided by the source element and/or the support, no further elements to provide the point-like or at least essentially point-like contact areas are necessary.

According to a further embodiment of a source arrangement according to the invention, the at least one source element comprises at least one reduction opening extending in the source element from the source surface to the second surface for a reduction of the thermal conductivity within the at least one source element. The direct surface heater of the deposition apparatus deposits heating power onto and/or into the source area on the source surface of the source element. Heat dissipation within the source element distributes this heating power within the source element. Especially in source materials with high thermal conductivity, this can lead, on the one hand, to unnecessary high energy consumption, as the heating power of the surface heater is distributed in the source element as a whole. On the other hand this can lead to a loss in localization of the source area. Reducing openings in the source element that extend through the source element from the source surface to the second surface can provide avoiding these problems. These reducing openings extend through the whole source element perpendicular to a radial direction starting at the source area and therefore perpendicular to the heat flow emanating from the source area. In other words, an effective cross section of the source element for this heat flow can be reduced, resulting in a better localization of the source area and simultaneously in a lower temperature at the contact areas. If necessary, the reducing openings can cover a whole circumference at a certain radial distance to the source area, except for one or more, preferably narrow, bridge section to provide structural integrity of the source element. Thermal dissipation in this radial direction in the source element is therefore interrupted and reduced. Therefore, the dissipation of the heating power of the direct surface heater stays localized at the source area. An improvement in control of the dissipated heating power and therefore in the deposition rate achievable with a source arrangement according to the invention can therefore be provided.

In a further embodiment of the source arrangement according to the invention, the at least one source element is divided in a first part and at least one second part separate to the first part, wherein the first part comprises the source surface and wherein the first part and at least one second part are stacked to form the source element, whereby the first part is supported by the at least one second part at three or more, preferably at three, support positions, wherein the contact area between the first part and the at least one second part at the support positions are point-like or at least essentially point-like contact areas, in particular wherein the first part and/or at least one second part comprise conical protrusions for providing the point-like or at least essentially point-like contact areas between the first part and the at least one second part. In other words, these stacked first and at least one second part provide a separation of different parts of the source element similar to the aforementioned reducing opening, but not only in radial direction but throughout the whole source element. For instance, if the first part and at least one second part are planar elements, the separation is perpendicular to the aforementioned radial direction.

In another embodiment, the first part and the at least one second part are shaped as a spherical half-shell, a spherically radial separation of the different parts can be provided. The usage of point-like or at least essentially point-like contact areas provide the same advantage as aforementioned with respect to the connection areas between the support and the source material. Especially, temperature conductivity by the physical contact at these point-like or at least essentially point-like areas can be minimized. In summary, a temperature gradient within the source element can therefore be optimized. Especially, a heat disposition through the source element as a whole can be lowered, providing especially low temperatures at locations of the source element in contact to the support, independent of the temperatures reached at the source area.

In a further embodiment of a source arrangement according to the invention, the at least one source element comprises at least one emission section for an emission of thermal energy, wherein the at least one emission section is provided by an emission region arranged radially in the source element with respect to the source area and/or is shaped as a protrusion protruding from the second surface, in particular wherein the at least one emission section is shaped as a protrusion protruding from the second surface, whereby the protrusion is shaped like a prism, in particular an oblique prism and/or like a cone and/or like an intersection of at least two of these shapes.

One of the sources of contamination, chemical reaction or alloy formation, as already mentioned above, are contact areas between the source element and the support of the holding structure. A severity of these contaminations, chemical reactions, or alloy formations depends especially on the temperature of the source element at these contact areas. An emission section arranged radially in the source element with respect to the source area can help to reduce the temperature of the source element at the contact areas, as these contact areas essentially in most of the cases essentially are located at and/or near an outer rim of the source element. Thermal energy is radiated away from the source element in the emission region and therefore the temperature at the contact areas is lower, in particular low enough that no or at least less contamination, chemical reaction, or alloy formation result. To achieve the best results, the emission region preferably surrounds the source area. Additionally, the emission region can comprise a small thickness perpendicular to the radial direction, thereby further reducing temperature conductivity in the radial direction. Thereby a temperature at the contact areas can be lowered further.

Similar advantages can be achieved by emission sections shaped as protrusions protruding from the second surface. These protrusions enlarge the total area of the second surface and thereby the possibility of emitting thermal energy by thermal radiation. Prism-shaped protrusions and/or cone-shaped protrusions are preferable embodiments of these protrusions, in particular as these shapes can be provided in an axially symmetric way. Preferably, the inlet guide section mentioned above can be integrated and/or be part of the protrusions used as an emission section.

In another embodiment, a source arrangement according to the invention can be characterized in that the source arrangement comprises an actuator for alternating the relative position of the source element within the source arrangement for a variation of the location of the source area on the source surface when heated by the surface heater of the deposition apparatus. In other words, this actuator can move the source element with respect to the source arrangement as a whole and hence with respect to the reaction chamber and the heating spot of the surface heater, respectively.

In particular, the actuator is part of the holding structure and/or the support. Preferably, the actuator can even be positioned outside of the reaction chamber of the respective deposition apparatus, and only a mechanical linkage is provided through a sealed opening in the wall into the reaction chamber. By changing the relative position of the source material within the source arrangement as a whole also the location of the heating spot, the impact point of the thermal energy of the direct surface heater is changed on the source surface. Hence, also the positioning of the source area on the source surface is changed. A better distribution of the heating power onto the source surface of the source element and hence of the removal of source material by evaporation or sublimation from the source surface can therefore be provided. An especially even source surface of the source material of the source element can therefore be maintained. This is important for a constant and reproducible deposition rate of source material on the target, as the deposition rate depends on the relative orientation of source surface, especially the source area, and target surface during deposition.

For example in a preferred embodiment, the body of the source element is essentially rotationally symmetric, the temperature sensor is located on the symmetry axis at the second surface, the source area is shaped as an ideally circular heating spot and is located at a fixed radial distance away from the symmetry axis on the source surface. Simultaneously, the source element is movable by the actuator around its symmetry axis. This moves the source area around the symmetry axis on a circular path. During this movement, the heat distribution in the source element rotates around the symmetry axis, but essentially does not change its shape in this rotating reference frame. In particular, the distance between source area and temperature sensor and therefore the temperature difference between source area and temperatures sensor does not change. With constant temperature at the temperature sensor, the evaporation rate does not change despite the rotating movement, allowing reliable control of the evaporation rate. If laser radiation is used by the surface heater, this radiation may be strongly focused to achieve large temperature differences to the temperature sensor and the support, respectively. Still, a larger area of the source surface is evenly removed, allowing the evaporation of larger amounts of source material without strongly affecting the local inclination of the source area with respect to the target and thereby the deposition rate on the target.

According to a second aspect of the invention the object is satisfied by a deposition apparatus, comprising a source arrangement with a source element, target arrangement with a target element, a reaction chamber comprising a wall and containing a reaction atmosphere, an atmosphere controller configured to control the reaction atmosphere and a surface heater configured to heat a source area on a source surface of the source element, whereby the source arrangement and the target arrangement are positioned with the reaction atmosphere within the reaction chamber such that the source material can be deposited on the target element in a controlled way by heating the source area by usage of the surface heater by applying a heating power onto a heating spot on the source surface, wherein the source arrangement is constructed according to the first aspect of the invention. The deposition apparatus according to the second aspect of the invention comprises a source arrangement according to the first aspect of the invention. Therefore, all advantages described above with respect to a source arrangement according to the first aspect of the invention can also be achieved by a deposition apparatus according to the second aspect of the invention.

Additionally, a deposition apparatus according to the invention can comprise a controller for controlling the temperature of the target. This controller can comprise both temperature sensors to measure the temperature of the target material and a target heater to adjust the temperature of the target material. Especially a closed loop control for the target temperature can be established. The temperature sensors can be contact sensors, as for example thermocouples, or contact-free sensors, as for example pyrometers. The target heater can preferably use a suitable laser beam for heating the target material.

Preferably, a deposition apparatus according to the invention can be characterized in that the surface heater comprises a laser light source for emitting laser light into the reaction chamber and/or an aperture in the wall of the reaction chamber for coupling laser light into the reaction chamber, whereby the laser light is directed onto the surface area on the source surface of the source element, and in particular wherein the laser light is an UV laser light and/or a visible laser light and/or an IR laser light, and/or wherein the reaction chamber comprises a cooler for cooling of the reaction chamber and/or the reaction atmosphere, in particular an active cooler, wherein the cooler is preferably arranged at and/or in the wall of the reaction chamber, and/or wherein the atmosphere controller comprises a vacuum pump for providing a reaction atmosphere with a pressure between 10⁻¹¹ mbar and 1 mbar.

Using a direct surface heater based on laser light comprises several advantages. First of all, the amount of electric components within the reaction chamber, for instance as needed for a surface heating with an electron beam source, can be drastically reduced. Limitations with respect to the reaction atmosphere, for instance with respect to corroding gases as reaction atmosphere and/or upper limits on the pressure of the reaction atmosphere, can therefore be avoided. Additionally, laser light can be provided over a wide range of energies, preferably starting with IR light up to UV light. In particular, for different source materials, an accordingly adapted laser light can be chosen. Further, in contrast to electron beam heating, a conductivity of the source material is not necessary and additionally evaporated or sublimated vapor is not ionized by electron impact.

Cooling the reaction chamber allows to further improve the quality of the reaction atmosphere. On the one hand, impurities in the reaction atmosphere can freeze out on these coolers and therefore the lower limits for a pressure of the reaction atmosphere can be lowered. On the other hand, a cooler can also be positioned such that reflected laser light is directed at these coolers and therefore an undesired heating of the reaction chamber and damage caused by reflected laser light can be avoided.

Providing a vacuum pump by means of which pressures down to 10⁻¹¹ mbar are possible in the reaction chamber, making available a wide range of reaction atmosphere pressures can be provided.

Essentially, all of the preferred embodiments mentioned above broaden the possible field of application of a deposition apparatus according to the invention.

In a third aspect of the invention the object is solved by a method for depositing source material on a target material in a deposition apparatus, the deposition apparatus comprising a surface heater and a source arrangement according to the first aspect of the invention, in particular in a deposition apparatus according to the second aspect of the invention, comprising the following steps:
a) Arranging the source arrangement and thereby providing the source element within the reaction chamber,
b) Heating the source area on the source surface of the source element by the surface heater by applying a heating power onto a heating spot on the surface for vaporizing and/or sublimating the source material,
c) Measuring a temperature of the source element by the temperature sensor of the source arrangement, and
d) Adjusting the heating of the source area by the surface heater according to the temperature measured in step c).

A method according to the invention can thus be carried out using a source arrangement according to the first aspect of the invention, in particular in a deposition apparatus according to the second aspect of the invention. All advantages described above with respect to a source arrangement according to the first aspect of the invention and/or with respect to a deposition apparatus according to the second aspect of the invention, can therefore also be achieved by a method for depositing source material according to the third aspect of the invention.

In a first step a) of the method according to the invention the source arrangement is arranged in the reaction chamber. The source arrangement according to the first aspect of the invention comprises a source element made out of source material. After step a) therefore there is a source element made out of source material arranged within the reaction chamber. Additionally, the source arrangement according to the first aspect of the invention also comprises a temperature sensor. Hence, no additional elements for providing a temperature measurement of the source element are necessary.

The next step b) comprises heating of the source area on the source surface of the source element by the surface heater. This can be provided by applying a heating onto a heating spot on the source surface by the surface heater, in particular using laser light. A vaporization and/or sublimation of the source material can therefore be provided.

In particular, in step c) a temperature of the source element is measured by the temperature sensor of the source arrangement. Therefore, after step c) information about the status of the source element, represented by the measured temperature, can be provided.

This information can be used in the next step d) for an adjustment of heating of the source area by the surface heater based on the temperature measured in step c). Especially a closed loop control can be established. A highly controllable deposition rate of source material onto a target material in the deposition apparatus can therefore be provided.

A method according to the invention can be improved in that step d) comprises an adjustment of the heating power provided by the surface heater onto the source area, in particular, wherein the adjustment of the heating power comprises a pulsed operation of the surface heater in at least one alternating on-phase and off-phase, whereby the heating power is adjusted by choosing suitable durations of the at least one on-phase and off-phase, in particular by choosing a suitable ratio of the durations of the at least one on-phase and off-phase.

A first possibility of adjusting the heating of the source area by the surface heater can be provided by directly adjusting the heating power provided by the surface heater at the source area. When laser light is used to provide the heating power onto the source area, this adjustment can be done by adjusting the output power of the laser via an electric control interface. Also accordingly used covers, slits and/or other light shade elements are possible.

Preferably, the adjustment of the heating power comprises a pulsed operation of the surface heater, in particular the laser source. By providing alternating on-phases and off-phases, a time averaged heating power can be provided. Adjusting the durations of on-phases and off-phases, especially adjusting a suitable ratio of the durations of the on-phases and off-phases, is an especially suitable way of providing a controlled adjustment of the heating power.

Additionally or alternatively, a method according to the invention can be characterized in that step d) comprises a spatial variation of a position of the source area at the source surface of the source element, in particular wherein the spatial variation of the position of the source area is brought about by altering a position of the heating spot of the surface heater relative to the surface element and/or by altering the position of the surface element relative to the position of the heating spot, in particular provided by the actuator of the source arrangement. In contrast to the aforementioned embodiment of a method according to the invention, in which a temporal averaging is used to adjust the average heating power, in this embodiment a spatial averaging is used to achieve the same advantages, namely a temporally or spatially peaked power distribution for high surface temperature in the peak, combined with a low average power. By variating a position of the source area at the source surface of the source element, the actual position at the source surface where the sublimation and/or vaporization takes place, changes. A distribution of the heating power onto the source surface and hence of the vaporization and/or sublimation of source material of the source element can therefore be provided.

This spatial variation of the position of the source area can be provided for instance by altering a position of the heating spot of the surface heater relative to the surface element. In other words, the source element stays spatially fixed and the position of the heating spot is altered.

In contrast to this also the spatial position of the heating spot can stay fixed and the position of the surface element relative to the position of the heating spot is altered, in particular provided by the actuator of the source arrangement. Also in this embodiment a distribution of the total provided heating power and hence of the vaporization and/or sublimation at the source surface of the source element can be provided.

Also a combination of the aforementioned two embodiments, a variation of the position of the heating spot and additionally a variation of the relative position of the surface element relative to the position of the heating spot, can be provided to further enhance the averaging an homogenization of the evaporation flux on the target.

The present invention is further described hereinafter with reference to illustrated embodiments shown in the accompanying drawings. There is shown:
- Fig. 1: a deposition apparatus,
- Fig. 2: two possible embodiments of source arrangements,
- Fig. 3: two further embodiments of source arrangements,
- Fig. 4: possible arrangements of the temperature sensor,
- Fig. 5: possible embodiments of protrusions as emission sections,
- Fig. 6: a source arrangement with an emission region,
- Fig. 7: a source arrangement with reducing openings,
- Fig. 8: possible embodiments of source arrangements with a source element split in several parts,
- Fig. 9: a temporal distribution of the heating power, and
- Fig. 10: possible embodiments for spatial variations of heating power onto a source surface.

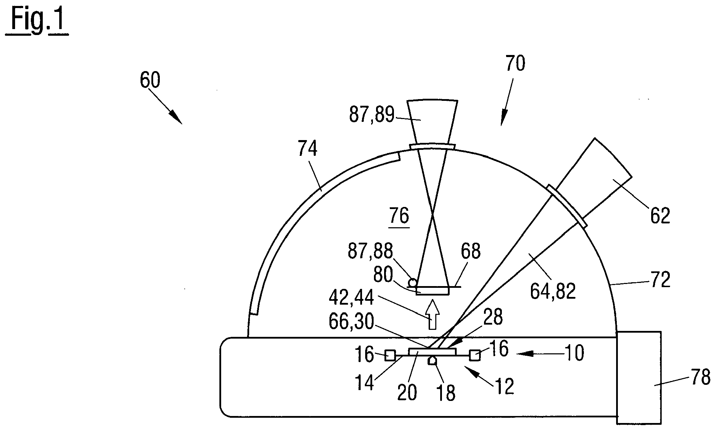

Fig. 1 shows a possible embodiment of a deposition apparatus 60 according to the invention. In the deposition apparatus 60 a source arrangement 10 according to the invention is arranged. The source arrangement 10 especially comprises a holding structure 12 with a support 14, wherein the support 14 supports the actual source element 20. A direct surface heater 62, in this embodiment a laser light source, provides laser light 64 directed onto a heating spot 66 of the source element 20, whereby the heating spot 66 corresponds to a source area 30 on the source surface 28. Source material 42 is vaporized and/or sublimated and the respective vapor 44 is deposited onto a target 80 held by a target arrangement 68 within the reaction chamber 70. The reaction chamber 70 is filled with a reaction atmosphere 76 controlled by an atmosphere controller 78, for instance a vacuum pump. A cooler 74 fitted into or near to the wall 72 of the reaction chamber 70 helps controlling the reaction atmosphere 76 and further absorbs reflected laser light 64.

According to a method according to the invention in a first step a) the source arrangement 10 is arranged within the reaction chamber 70. The next step b) comprises a heating of the source area 30 by applying a heating power 82 onto a heating spot 66 on the source element 20. In particular, in the next step c) a temperature of the source element 20 is measured by the temperature sensor 18 of the source arrangement 10 according to the invention. In the last step d) of a method according to the invention, this permits an adjustment of the heating of the source area 30 by the surface heater 62 based on the temperature measured by the temperature sensor 18 in step c). In other words, this allows establishing a closed loop control of the heating power 82 based on the measured temperatures of the source element 20.

Additionally, the deposition apparatus 60 shown in Fig. 1 comprise a temperature controller 87 for controlling the temperature of the target 80. This temperature controller 87 can comprise both temperature sensors 88 to measure the temperature of the material of target 80 and a target heater 89 to adjust the temperature of the material of target 80. Especially a closed loop control for the temperature of the material of target 80 can be established. The temperature sensors 88 can be contact sensors, as for example thermocouples, or contact-free sensors, as for example pyrometers. The target heater 89 can, as depicted in Fig. 1, preferably use a suitable laser beam for heating the material of target 80.

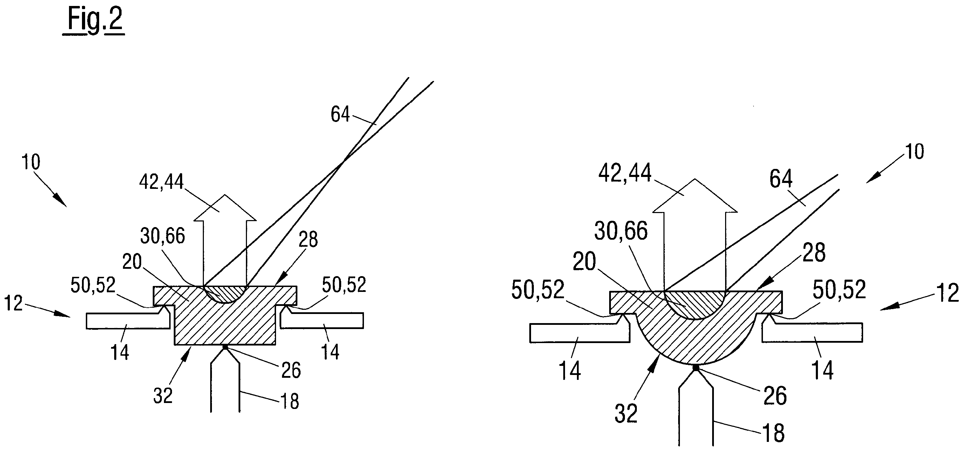

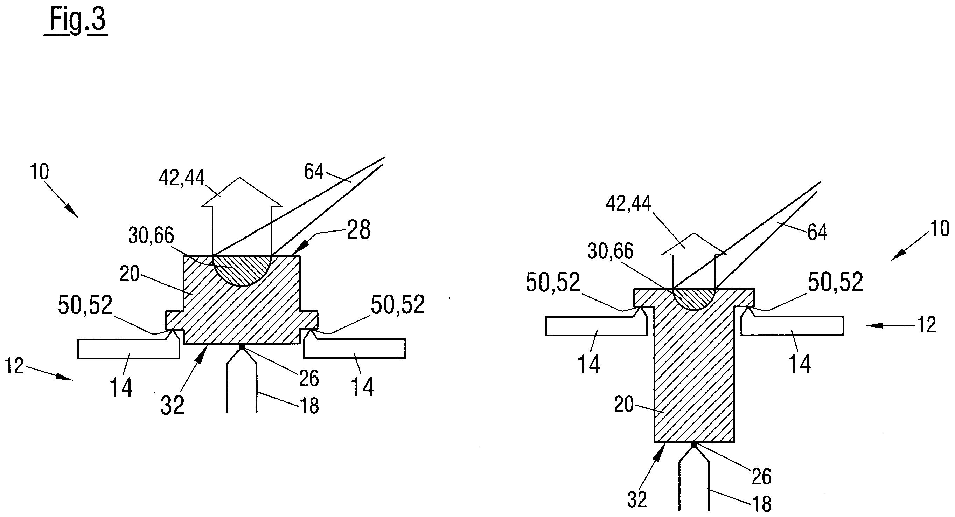

Fig. 2 and 3 show possible embodiments of source arrangements 10 according to the invention. In all embodiments, a holding structure 12 comprises a support 14 with cone-shaped protrusions to provide point-like contact areas 52 at the support positions 50 for the respective source element 20 of each source arrangement 10. Each of the source elements 20 is constructed self-supporting and especially without any crucible. Further, each of the source arrangements 10 comprises a temperature sensor 18 directly connected to a second surface 32 of the respective source element 20, especially at a symmetrical center 26 of the second surface 32. This second surface 32 is in all of the embodiments located opposite to the source surface 28 which comprises in its center the source area 30 heated by the heating spot 66 of the laser light 64. Vapor 44 made out of vaporized and/or sublimated source material 42 is indicated by an arrow.

The left embodiment shown in Fig. 2 is an initial point of design of the source elements 20 used in the source arrangement 10 according to the invention. The source element 20 is self-supporting and in particular rotationally symmetric. All surfaces, besides the point-like contact areas 52, are accessible and can be used for thermal regulation of the source element 20 by radiation cooling. At the source area 30, the source material 42 is melted and evaporated and/or sublimated into the vapor 44.

The embodiment shown on the right side of Fig. 2 is now optimized with respect to material utilization. During the use of the source arrangement 10, the source material 42 is vaporized and/or sublimated and therefore the source element 20 slowly gets less and less. In this embodiment the source element 20 is essentially shaped as a half sphere and therefore the fraction of the source element 20 actually usable for vaporization and/or sublimation is maximized.

The embodiment shown on the left side of Fig. 3 is suitable especially for locations, where essentially the whole surface area 28 should be usable as source area 30. Therefore, the source element 20 is elongated well above the support 14 and therefore a vaporization and/or sublimation of the source surface 28 as a whole can be provided. In this embodiment, preferably the support is also movable in vertical direction to provide a constant distance from the source area 30 to the target 80.

The embodiment shown on the right side of Fig. 3 is suitable for source element 20 comprising a source material 42 with high thermal conductivity. The second surface 32 and especially the elongated part of the source element 20 along its vertical direction can radiate thermal energy and therefore the source area 30 can be better contained on the source surface 28. Without the radiation of thermal energy, a melting of the source element 20 as a whole is at risk.

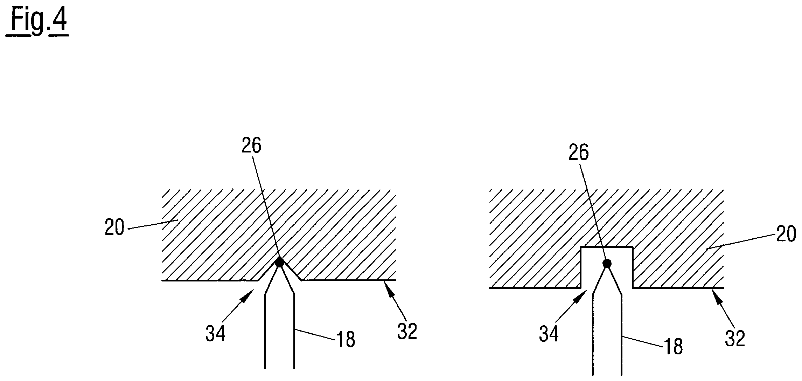

Fig. 4 shows two possible arrangements of a temperature sensor 18 at the second surface 32, whereby both embodiments comprise an inlet guide section 34 to guide the temperature sensor 18 into its desired position at a symmetrical center 26 of the source element 20.

As shown on the left side in Fig. 4, a direct contact, for instance for a thermocouple element used as temperature sensor 18, can be provided easily by a conical inlet guide section 34.

As shown on the right side of Fig. 4, also a cylindrical inlet guide section 34 can be used. This can be preferably established for source materials 42 with very high melting points and very low vapor pressures, when the temperature of the source element 20 is expected to be higher than bearable for the temperature sensor 18. In this case, no direct contact between the temperature sensor 18 and the source element 20 should be established. The tip of the temperature sensor 18 drawn is surrounded in 5 out of 6 orthogonal spatial directions by surfaces of the source element 20, effecting a strong radiative coupling to the temperature of the source element 20. In particular, a pyrometer element can be used as a temperature sensor 18 in these embodiments.

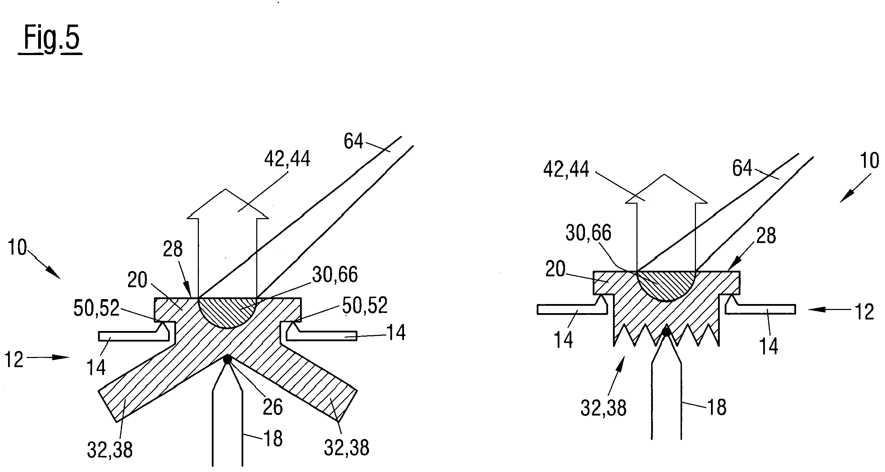

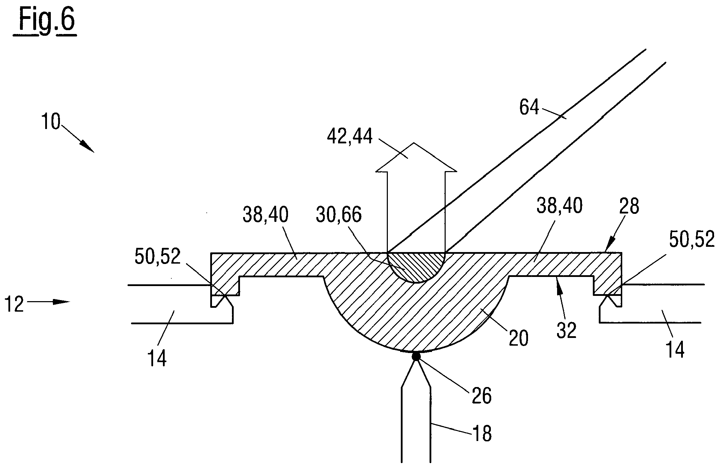

The next two Figs. 5 and 6 show other possible embodiments of a source arrangement 10 similar to the embodiment shown on the right side of Fig. 3, with respect to the requirement that thermal radiation has to be emitted from the source element 20. For all other elements of the depicted source arrangements 10 shown in Figs. 5 and 6 please refer to the Figs. 2 and 3.

In the embodiment shown on the left side of Fig. 5, emission sections 38 are provided, essentially as protrusions protruding from the second surface 32. In this embodiment, the protrusions are conical and extend far away from the source surface. Hence, an especially large second surface 32 and an especially effective radiation cooling can be provided.

On the right side of Fig. 5 other protrusions are used as emission sections 38 at the second surface 32, whereby in this embodiment the protrusions are prism-shaped. For instance, such protrusions can be provided by etching and/or milling and effectively enlarge the second surface 32 in an especially easy way.

Fig. 6 shows a different embodiment of an emission section 38, whereby this emission section 38 is provided by an emission region 40 arranged radially around the source area 30. This embodiment is especially advantageous for source materials 42 with high thermal conductivity, because a chemical reaction or the formation of an alloy, in particular an eutectic, between the source element 20 and the support 14 at the contact areas 52, which is essentially temperature dependent, can be effectively avoided by radiating away thermal energy by the emission region 40.

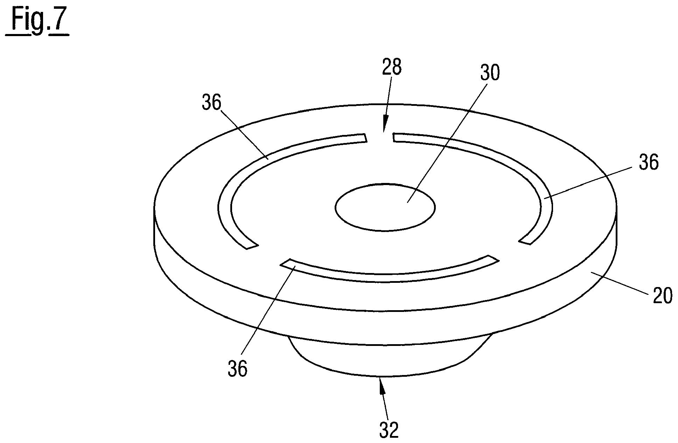

Opposite to that, in other cases, thermal energy should be contained at the source area 30. Fig. 7 shows a source element 20 which comprises reducing openings 36 extending between the source surface 28 and the second surface 32. These reducing openings 36 effectively reduce the thermal conductivity in radial direction within the source element 20. Therefore the heating power 82 projected onto the source area 30 stays contained in the middle of the source element 20 and is not or at least less distributed over the source element 20 as a whole.

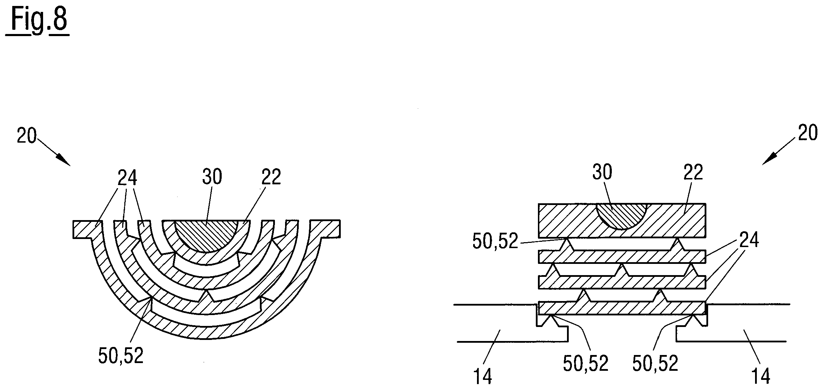

Fig. 8 shows another two possible embodiments of source elements 20, whereby these source elements 20 comprise a first part 22 and several second parts 24.

The embodiment shown on the left side comprises sphere-shell-like parts 22, 24 the embodiment shown on the right side comprises plane-like parts 22, 24. The parts 22, 24 are stacked together, similar to the connection between the support 14 and the source element 20 by providing support positions 50 and point-like contact areas 52. The support positions 50 and the contact areas 52 are provided by the conical protrusions of the several second parts 24. The respective first parts 22 provide the source area 30. These arrangements have two major advantages, first of all if the first part 22 is completely melted, the succeeding second part 24 catches the liquefied first part 22 and a spoiling of the source material 42 can be avoided. Additionally, due to the thermal isolation described already above, the last second part 24, which is in contact with the support 14, is at a relative low temperature and therefore contact contaminations, chemical reactions and/or alloy and eutectic formations at the support positions 50 between the last second part 24 and the support 14 can be avoided.

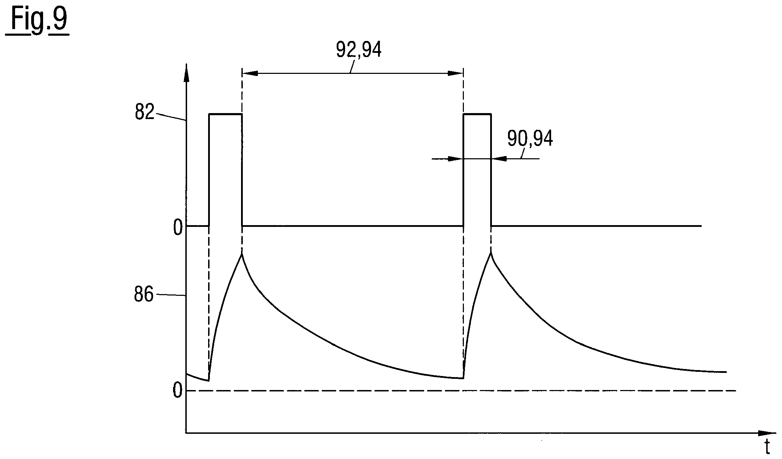

In Fig. 9, a temporal variation of the heating power 82 with respect to the duration (t) is shown. This can be used to adjust the heating power 82 in step d) of a method according to the invention. The upper part of the graph in Fig. 9 shows the actual heating power 82 provided by the surface heater 62. Especially, the heating power 82 is provided in on-phases 90 and off-phases 92 with different durations 94. The lower part of the graph in Fig. 9 shows the surface temperature 86 present at the source area 30 of the source element 20. By an adapted ratio of the durations 94 of the on-phases 90 and off-phases 92, a median heating power 82 can be provided, whereby for instance a vaporization and/or sublimation of source material 42 is provided during the on-phases 90, but due to the cooling during the off-phase 92 a complete melting of the source element 20 can be avoided. While the surface temperature 86 at the end of the on-phases 90 is maximal, leading to strong evaporation or sublimation, the average surface temperature 86, leveling out away from the source area 30 due to non-instantaneous thermal conduction to the temperature sensor 18 and support 14, is reduced according to the duration ratio between the on-phases 90 and the off-phases 92.

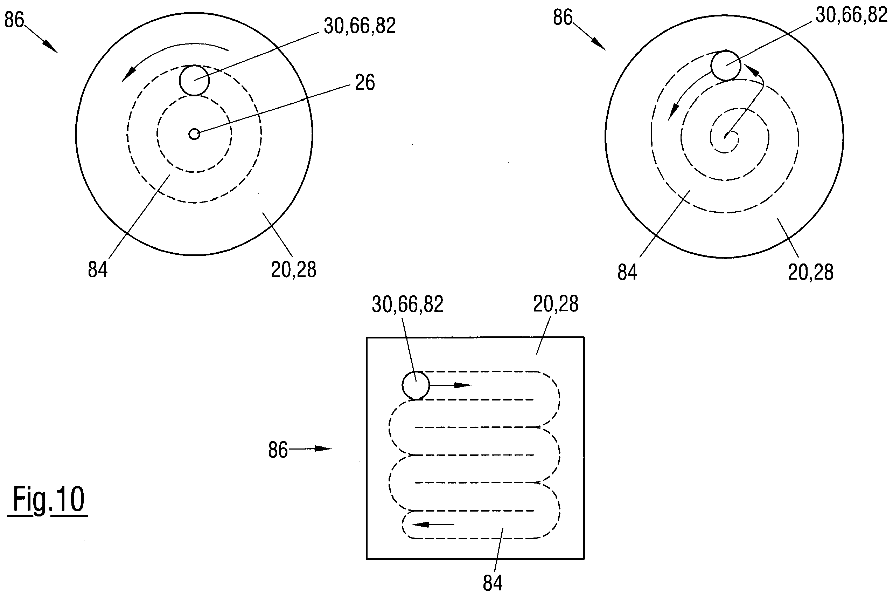

Fig. 10 shows a different possibility of achieving high peak surface temperatures 86 at the source area 30 with low average surface temperatures 86 at the temperature sensor 18 and support 14 (see Fig. 2, 3, 5, 6), especially to spatially spread the heating power 82 onto a larger part of the source surface 28 for more efficient radiative cooling. This can be provided either by moving the source element 20 relative to the heating spot 66 or vice versa. Also a combined movement of the source element 20 and the heating spot 66 can be used. In summary, the heating power 82 is distributed over the source surface 28, providing a more distributed irradiation to prevent a complete melting of the source element 20. Also a more evenly vaporization and/or sublimation of source material 42 can be provided. The three embodiments shown in Fig. 10 depict different possibilities of this approach.

The upper left embodiment shown in Fig. 10 is a simple circular movement of the heating spot 66 on the source surface 28 of the source element 20. This can for instance be provided by simply rotating the source element 20 around its symmetrical center 26, especially by using an actuator 16 of the source arrangement 10. It is a preferred embodiment that the temperature sensor 18 on the second surface 28 may be located on the symmetrical center 26 and hence on the rotation axis, thereby having a constant distance to the heating spot 66. Despite the heating spot 66 circling around the symmetrical center 26, the measured or controlled surface temperature 86, especially the surface temperature 86 at the source area 30, remains constant during the rotation, as the thermal distribution remains constant in the rotating reference frame or coordinate system of the heating spot 66.

The upper right embodiment is similar, but in this case the movement of the heating spot 66 is a spiral one.

For rectangular source elements 20, a meander-like path of the heating spot 66 on the source surface 28 of the source element can be advantageous, as shown in the lower part of Fig. 10.

In all of the embodiments the heating power 82 is sequentially distributed over a larger area on the source surface 28 of the source element 20. Therefore a more distributed vaporization and sublimation of the source material 42 can easily be provided.

### Reference signs

- 10: source arrangement
- 12: holding structure
- 14: support
- 16: actuator
- 18: temperature sensor

- 20: source element
- 22: first part
- 24: second part
- 26: symmetrical center
- 28: source surface
- 30: source area
- 32: second surface
- 34: inlet guide section
- 36: reducing opening
- 38: emission section
- 40: emission region
- 42: source material
- 44: vapour

- 50: support position
- 52: contact area

- 60: deposition apparatus
- 62: surface heater
- 64: laser light
- 66: heating spot
- 68: target arrangement
- 70: reaction chamber
- 72: wall
- 74: cooler
- 76: reaction atmosphere
- 78: atmosphere controller
- 80: target
- 82: heating power
- 84: spatial variation
- 86: surface temperature
- 87: temperature controller
- 88: temperature sensor
- 89: target heater

- 90: on-phase
- 92: off-phase
- 94: duration

## Claims

1. Source arrangement (10) for a deposition apparatus (60) with a direct surface heater (62), comprising a holding structure (12) with a support (14) and at least one source element (20) comprising, in particular consisting of, a source material (42) and arranged at the support (14), the source element (20) comprising a source surface (28) and a second surface (32) opposite of the source surface (28), wherein source material (42) can be vaporized and/or sublimated from a source area (30) on the source surface (28) when heated by the surface heater (62) of the deposition apparatus (60), wherein the source arrangement (10) comprises a temperature sensor (18) for a temperature measurement at the source element (20).

2. Source arrangement (10) according to claim 1,
wherein the temperature sensor (18) is arranged at the second surface (32) of the source element (20), in particular wherein the temperature sensor (18) is arranged at and/or near to a symmetric center (26) of the second surface (32) and/or the source element (20).

3. Source arrangement (10) according to claim 2,
wherein the second surface (32) comprises an inlet guide section (34) for guiding the temperature sensor (18) into its position, in particular an at least partially conical and/or cylindrical inlet guide section (34), arranged at the source element (20) at a symmetric center (26) of the second surface (32) and/or the source element (20), preferably extending inward into the source element (20).

4. Source arrangement (10) according to one of the claims 2 or 3,
wherein the temperature sensor (18) is arranged in direct contact with the second surface (32), wherein in particular the temperature sensor (18) comprises a thermocouple element and/or
wherein the temperature sensor (18) is arranged spaced apart from the second surface (32), wherein in particular the temperature sensor (18) comprises a pyrometer element.

5. Source arrangement (10) according to one of the preceding claims,
wherein the at least one source element (20) is supported by the support (14) at three or more, preferably at three, support positions (50), wherein the contact areas (52) between the support (14) and the source element (20) at the support positions (50) are point like or at least essentially point like contact areas (52).

6. Source arrangement (10) according to claim 5,
wherein the at least one source element (20) and/or the support (14) comprise conical protrusions for providing the point like or at least essentially point like contact areas (52) between the support (14) and the at least one source element (20).

7. Source arrangement (10) according to one of the preceding claims,
wherein the at least one source element (20) comprises at least one reducing opening (36) extending in the source element (20) from the source surface (28) to the second surface (32) for a reduction of thermal conductivity within the at least one source element (20).

8. Source arrangement (10) according to one of the preceding claims,
wherein the at least one source element (20) is divided in a first part (22) and at least one second part (24) separate to the first part (22), wherein the first part (22) comprises the source surface (28) and wherein the first part (22) and the at least one second part (24) are stacked to form the source element (20), whereby the first part (22) is supported by the at least one second part (24) at three or more, preferably at three, support positions (50), wherein the contact areas (52) between the first part (22) and the at least one second part (24) at the support positions (50) are point like or at least essentially point like contact areas (52), in particular wherein the first part (22) and/or the at least one second part (24) comprise conical protrusions for providing the point like or at least essentially point like contact areas (52) between the first part (22) and the at least one second part (24).

9. Source arrangement (10) according to one of the preceding claims,
wherein the at least one source element (20) comprises at least one emission section (38) for an emission of thermal energy, wherein the at least one emission section (38) is provided by an emission region (40) arranged radially in the source element (20) with respect to the source area (30) and/or is shaped as a protrusion protruding from the second surface (32),
in particular wherein the at least one emission section (38) is shaped as a protrusion protruding from the second surface (32), whereby the protrusion is shaped like a prism, in particular an oblique prism, and/or like a cone and/or like an intersection of at least two of these shapes.

10. Source arrangement (10) according to one of the preceding claims,
wherein the source arrangement (10) comprises an actuator (16) for altering the relative position of the source element (20) within the source arrangement (10) for a variation of the location of the source area (30) on the source surface (28) when heated by the surface heater (62) of the deposition apparatus (60).

11. Deposition apparatus (60), comprising a source arrangement (10) with a source element (20), a target arrangement (68) with a target element, a reaction chamber (70) comprising a wall (72) and containing a reaction atmosphere (76), an atmosphere controller (78) configured to control the reaction atmosphere (76) and a surface heater (62) configured to heat a source area (30) on a source surface (28) of the source element (20), whereby the source arrangement (10) and the target arrangement (68) are positioned within the reaction atmosphere (76) in the reaction chamber (70) such that the source material (42) can be deposited on the target element in a controlled way by heating the source area (30) by usage of the surface heater (62) by applying a heating power (82) onto a heating spot (66) on the source surface (28),
wherein the source arrangement (10) is constructed according to one of the preceding claims.

12. Deposition apparatus (60) according to claim 11,
wherein the surface heater (62) comprises a laser light source for emitting laser light (64) into the reaction chamber (70) and/or an aperture in the wall (72) of the reaction chamber (70) for coupling of laser light (64) into the reaction chamber (70), whereby the laser light (64) is directed onto the source area (30) on the source surface (28) of the source element (20), and in particular wherein the laser light (64) is an UV laser light (64) and/or a visible laser light (64) and/or an IR laser light (64),
and/or
wherein the reaction chamber (70) comprises a cooler (74) for cooling of the reaction chamber (70) and/or the reaction atmosphere (76), in particular an active cooler (74), wherein the cooler (74) is preferably arranged at and/or in the wall (72) of the reaction chamber (70), and/or
wherein the atmosphere controller (78) comprise a vacuum pump for providing a reaction atmosphere (76) with a pressure between 10⁻¹¹ mbar and 1 mbar.

13. Method for depositing source material (42) on a target material in a deposition apparatus (60), the deposition apparatus (60) comprising a surface heater (62) and a source arrangement (10) according to one of the claims 1 to 10, in particular in a deposition apparatus (60) according to one of the claims 11 or 12, comprising the following steps:
a) Arranging the source arrangement (10) and thereby providing the source element (20) within the reaction chamber (70),
b) Heating the source area (30) on the source surface (28) of the source element (20) by the surface heater (62) by applying a heating power (82) onto a heating spot (66) on the source surface (28) for vaporizing and/or sublimating the source material (42),
c) Measuring a temperature of the source element (20) by the temperature sensor (18) of the source arrangement (10), and
d) Adjusting the heating of the source area (30) by the surface heater (62) according to the temperature measured in step c).

14. Method according to claim 13,
wherein step d) comprises an adjustment of the heating power (82) provided by the surface heater (62) onto the source area (30),
in particular wherein the adjustment of the heating power (82) comprises a pulsed operation of the surface heater (62) in at least one alternating on-phase (90) and off-phase (92), whereby the heating power (82) is adjusted by choosing suitable durations (94) of the at least one on-phase (90) and off-phase (92), in particular by choosing a suitable ratio of the durations (94) of the at least one on-phase (90) and off-phase (92).

15. Method according to one of the claims 13 or 14,
wherein step d) comprises a spatial variation (84) of a position of the source area (30) on the source surface (28) of the source element (20),
in particular wherein the spatial variation (84) of the position of the source area (30) is brought about by altering a position of the heating spot (66) of the surface heater (62) relative to the surface element and/or by altering the position of the surface element relative to the position of the heating spot (66), in particular provided by the actuator (16) of the source arrangement (10).
